**Europäisches Patentamt**

**European Patent Office**

**Office européen des brevets**

(19)

(11) Veröffentlichungsnummer : **0 078 898**
**B1**

(12) **EUROPÄISCHE PATENTSCHRIFT**

(45) Veröffentlichungstag der Patentschrift :
24.04.85

(51) Int. Cl.⁴ : **G 01 R 17/10**

(21) Anmeldenummer : 82108302.9

(22) Anmeldetag : 09.09.82

(54) **Brückenschaltung für Messzwecke.**

(30) Priorität : 24.10.81 DE 3142325

(43) Veröffentlichungstag der Anmeldung :
**18.05.83 Patentblatt 83/20**

(45) Bekanntmachung des Hinweises auf die Patenterteilung : 24.04.85 Patentblatt 85/17

(84) Benannte Vertragsstaaten :
**DE FR GB**

(56) Entgegenhaltungen :
DE-B- 1 473 596
GB-A- 2 068 130
TM-TECHNISCHES MESSEN, Band 48, Nr. 4, April
1981, München
REVIEW OF SCIENTIFIC INSTRUMENTS, Band 52, Nr.
9, September 1981, New York

(73) Patentinhaber : **Hewlett-Packard GmbH**
**Herrenberger Strasse 110**
**D-7030 Böblingen (DE)**

(72) Erfinder : **Traub, Stefan**
**Offenburger Strasse 16**
**D-7030 Böblingen (DE)**

(74) Vertreter : **Schulte, Knud, Dipl.-Ing.**
**c/o Hewlett-Packard GmbH Europ. Patent- und Lizen-**
**zabteilung Postfach 1430 Herrenberger Strasse 130**
**D-7030 Böblingen (DE)**

**Beschreibung**

Die vorliegende Erfindung betrifft eine Brückenschaltung für Meßzwecke gemäß dem Oberbegriff des Anspruchs 1.

Derartige Brückenschaltungen bestehen im allgemeinen aus vier Impedanzelementen, von denen mindestens eines ein Meßfühler ist, z. B. ein Dehnungsmeßstreifen für die Längenmessung oder ein Thermistor für die Temperaturmessung. Der Vorteil einer solcher Brückenschaltung besteht darin, daß auch kleine Impedanzänderungen des Meßfühlers exakt erfaßt werden können. Die Brückenschaltung kann mit relativ großen Spannungen bzw. Strömen gespeist werden. Das abgegriffene Meßsignal hat jedoch nur eine Spannung bzw. einen Strom, die bzw. der der Impedanzänderung des Meßfühlers entspricht, nicht jedoch dessen absoluter Impedanz. Das Meßsignal ist also frei von der relativ Ruhespannung am Meßfühler bzw. von dessen Ruhestrom.

Der Nachteil einer Brückenschaltung besteht darin, daß Versorgungsspannung bzw. Versorgungsstrom einerseits und Meßspannung bzw. Meßstrom andererseits kein gemeinsames Bezugspotential haben und daher eine galvanische Trennung zwischen Versorgung und Weiterverarbeitung des Meßsignals erforderlich ist.

Es ist bekannt, die galvanische Trennung dadurch zu vermeiden, daß das Meßsignal an der entsprechenden Brückendiagonale einem Differenzverstärker zugeführt wird. Das Ausgangssignal des Differenzverstärkers bezieht sich dann weiter auf die gemeinsame Masse der Schaltung. Die dazu benötigten Differenzverstärker müssen aber eine hohe Gleichtaktunterdrückung aufweisen, damit die im Verhältnis zur Versorungsspannung bzw. zum Versorgungsstrom kleinen Differenzsignale exakt gemessen werden können. Die Realisierung solcher Differenzverstärker erfordert Präzisionsbauteile, und zwar hauptsächlich Widerstände, die jeweils paarweise gleich sein müssen. Nicht selten ist eine Gleichtaktunterdrückung von 60 bis 80 dB notwendig. Aber auch bei Präzisionsbauteilen verbleibt z. B. die Temperaturabhängigkeit, die sich nicht oder nur mit verhältnismäßig großem Aufwand kompensieren läßt.

Aus der GB-PS 20 68 130 ist eine Brückenschaltung für Meßzwecke bekannt, bei der ein Brückeneckpunkt mittels eines Operationsverstärkers virtuell auf Bezugspotential (Masse) gelegt ist. Die Brückenschaltung ist Teil eines Oszillators, dessen Frequenz sich mit dem als Meßwiderstand dienenden Brückenzweig ändert. Sie eignet sich daher nicht für Fälle, in denen ein Gleichspannungsausgangssignal erwünscht ist.

Der vorliegende Erfindung liegt die Aufgabe zugrunde, eine Brückenschaltung der eingangs genannten Art zu schaffen, bei der keine galvanische Trennung zwischen Versorgung und Meßschaltung erforderlich ist, die trotzdem mit einfachen Bauteilen auskommt und ein Gleichspannungsausgangssignal liefert. Bei einer Brückenschaltung nach dem Oberbegriff des Anspruchs 1 ist dazu eine potentialfreie konstante Versorgungsspannung erforderlich. Die Lösung dieser Aufgabe ist im Anspruch 1 gekennzeichnet.

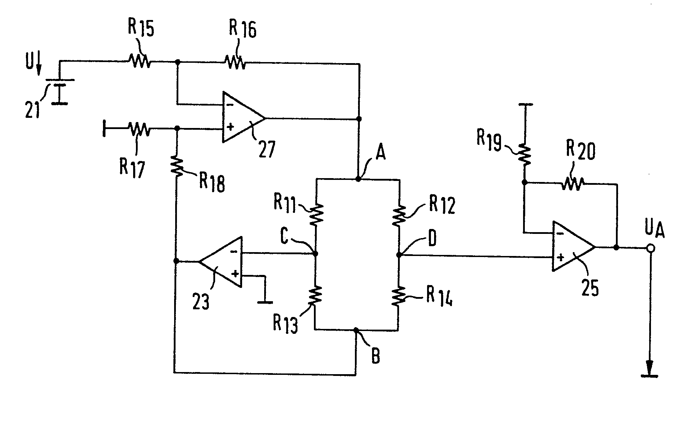

Aus der Zeitschrift Technisches Messen, Vol. 48, April 1981, Nr. 4, München, Seiten 127-130, ist nach Bild 3 die Spannungsversorgung einer Brückenschaltung über eine Operationsverstärkerschaltung mit einer Referenzdiode zur Erzeugung einer konstanten Versorgungsspannung bekannt. Diese bekannte Schaltung gibt jedoch keine potentialfreie Versorgungsspannung ab und ist für die vorliegende Aufgabe nicht geeignet, weil wiederum zur Verstärkung des Ausgangssignals Differenzverstärker mit hoher Gleichtaktunterdrückung erforderlich sind.

Die erfindungsgemäße Brückenschaltung benötigt keine Differenzverstärker mit hoher Gleichtaktunterdrückung, kommt mit wenigen und dabei noch vergleichsweise billigen Bauelementen aus und gibt an ihrem Ausgang kein von der Brückenversorgung herrührendes Signal ab, das dem eigentlichen Differenzsignal überlagert ist. Das Ausgangssignal läßt sich mittels eines weiteren Operationsverstärkers rückwirkungsfrei zu einem auf Masse bezogen Leistungssignal verstärken (Anspruch 2).

Die Erfindung wird im folgenden anhand eines Ausführungsbeispiels in Verbindung mit der zugehörigen Zeichnung erläutert, in der eine Brückenschaltung dargestellt ist, die von einer konstantspannungsquelle versorgt wird.

In der Zeichnung ist mit 10 eine Widestandsbrückenschaltung mit den Widerständen $R_{11}$, $R_{12}$, $R_{13}$ und $R_{14}$ bezeichnet. Die vier Eckpunkte der Brücke sind mit A, B, C und D bezeichnet. Der Brückeneckpunkt B ist mit dem Ausgang eines Operationsverstärkers 23 verbunden, dessen negativer Eingang mit dem Brückeneckpunkt C und dessen positiver Eingang mit Masse verbunden ist. Der Operationsverstärker 23 ist nicht mit zusätlichen Impedanzen beschaltet und dient dazu, den Brücken eckpunkt C virtuell auf Massepotential zu halten, und zwar unabhängig davon, wie hoch die Spannung zwischen den brückeneckpunkten A und Bist und wie stark die Brücke verstimmt ist.

An dem dem Brückeneckpunkt C gegenüberliegenden Brückeneckpunkt D wird die Meßspannung abgegriffen, die auf Massepotential bezogen ist, da sich der Brückeneckpunkt C auf Massepotential befindet. Die Meßspannung am Brückeneckpunkt D läßt sich mit einem einfachen Gleichspannungsverstärker 25 verstärken, der in üblicher Weise mit Widerständen $R_{19}$ und $R_{20}$ beschaltet ist. Die Ausgangsspannung $U_A$ des Verstärkers 25 ist proportional zur Spannung zwischen den Brückeneckpunkten D und C und ist auf Massepotential bezogen. Sie kann z. B. einem Anzeigegerät zugeführt werden.

Von den Widerständen $R_{11}$, $R_{12}$, $R_{13}$ und $R_{14}$ ist mindestens einer ein Meßfühler, der sich mit der zu messenden Größe ändert, z. B. ein Dehnungsmeßstreifen oder ein Thermistor.

An den Brückeneckpunkten A und B ist eine konstante Spannung angelegt. Eine Gleichspannungsquelle 21 mit der konstanten Spannung U ist über einen Widerstand $R_{15}$ einerseits mit dem negativen Eingang eines Operationsverstärkers 27 und andererseits über einen weiteren Widerstand $R_{16}$ mit dem Brückeneckpunkt A verbunden. Der positive Eingang des Operationsverstärkers 27 ist über einen Widerstand $R_{17}$ mit Masse und über einen Widerstand $R_{18}$ mit dem Brückeneckpunkt B verbunden. Unter der Voraussetzung, daß $R_{15} = R_{17}$ und $R_{16} = R_{18}$ sind, gilt für die Spannung zwischen den Brückeneckpunkten A und B :

$$U_{AB} = - U(R_{16}/R_{15}) \tag{1}$$

Für die Spannung am Brückeneckpunkt D gilt :

$$U_D = U_{AB}[R_{12}/(R_{12} + R_{14})] - [R_{11}/(R_{11} + R_{13})] \tag{2}$$

**Patentansprüche**

1. Brückenschaltung für Meßzwecke, bei der
    1. mindestens ein Impedanzelement entsprechend einer Meßgrösse variabel ist,
    2. an eine erste Brückendiagonale (A, B) eine Versorgungssspannung angelegt ist,
    3. an einer zweiten Brückendiagonale (C, D) ein der Meßgrösse entsprechendes Signal abgegriffen wird und
    4. der eine Eckpunkt der zweiten Brückendiagonale (C) mittels eines Operationsverstärkers (23) virtuell auf Masse gelegt ist, gekennzeichnet durch forgende Merkmale :
    5. der invertierende Eingang eines zweiten Operationsverstärkers (27) ist über einen ersten Widerstand (R 15) mit einem Pol einer Gleichspannungsquelle (21) und über einen zweiten Widerstand (R 16) mit dem Ausgang des zweiten Operationsverstärkers (27) sowie mit einem Eckpunkt (A) der ersten Brückendiagonale (A, B) verbunden ;
    6. der nicht-invertierende Eingang des zweiten Operationsverstärkers (27) ist über einen dritten Widerstand (R 17) mit dem anderen Pol der Gleichspannungsquelle und über einen vierten Widerstand (R 18) mit dem zweiten Eckpunkt (B) der ersten Brückendiagonale (A, B) verbunden ;
    7. ein Pol der Gleichspannungsquelle liegt auf Masse.
2. Brückenschaltung nach Anspruch 1, gekennzeichnet durch folgende Merkmale :
    1. der andere Eckpunkt (D) der zweiten Brückendiagonale (C, D) ist mit dem Eingang eines Gleichspannungsverstärkers (25) verbunden ;
    2. der Gleichspannungsverstärker (25) gibt an seinem Ausgang eine auf Massepotential bezogen Ausgangsspannung (UA) ab, die proportional zum Signal in der zweiten Brückendiagonale ist.

**Claims**

1. A bridge circuit for measuring purposes in which
    1. at least one impedance element is variable in accordance with an entity to be measured,
    2. a supply voltage is applied to a first bridge diagonal (A, B),
    3. a signal corresponding to the measured entity is derivated at a second bridge diagonal (C, D), and
    4. one junction of the second bridge diagonal (C) is virtually connected to ground by means of an operational amplifier (23) characterized by the following features :
    5. the inverting input of a second operational amplifier (27) is connected via a first resistor (R 15) to a terminal of a d.c. voltage source (21), and connected via a second resistor (R 16) to the output of the second operational amplifier (27) and to a junction (A) of the first bridge diagonal (A, B) ;
    6. the non-inverting input of the second operational amplifier (27) is connected via a third resistor (R 17) to the other terminal of the d. c. voltage source, and via a fourth resistor (R 18) to the second junction (B) of the first bridge diagonal ;
    7. one terminal of the d. c. voltage source is connected to ground.
2. A bridge circuit as in claim 1, characterized by the following features :
    1. The other junction (D) of the second bridge diagonal (C, D) is connected to the input of d. c. amplifier (25),
    2. at its output the d. c. amplifier (25) supplies an output voltage (UA), referenced to ground potential, which is proportial to the signal in the second bridge diagonal.

**Revendications**

1. Circuit en pont utilisé pour la mesure et dans lequel
    1. au moins un élément d'impédance est variable conformément à une grandeur de mesure,

2. une tension d'alimentation est appliquée à une première diagonale (A, B) du pont,

3. un signal correspondant à la grandeur de mesure est prélevé dans une seconde diagonale (C, D) du pont,

4. une extrémité (C) de la seconde diagonale du pont est placé virtuellement à la masse au moyen d'un amplificateur opérationnel (23), caractérisé par les caractéristiques suivantes :

5. L'entrée inverseuse d'un second amplificateur opérationnel (27) est reliée par l'intermédiaire d'une première résistance (R 15) à un pôle d'une source de tension continue (21) et, par l'intermédiaire d'une seconde résistance (R 16), à la sortie du second amplificateur opérationnel (27) ainsi qu'à une extrémité (A) de la première diagonale (A, B) du pont ;

6. L'entrée non inverseuse du second amplificateur opérationnel (27) est reliée par l'intermédiaire d'une troisième résistance (R 17) à l'autre pôle de la source de tension continue et, par l'intermédiaire d'une quatrième résistance (R 18), à la seconde extrémité (B) de la première diagonale (A, B) du pont ;

7. un pôle de la source de tension continue est placé à la masse.

2. Circuit en pont selon la revendication 1, caractérisé par les caractéristiques suivantes :

1. l'autre extrémité (D) de la seconde diagonale (C, D) du pont est reliée à l'entrée d'un amplificateur de tension continue (25) ;

2. l'amplificateur de tension continue (25) délivre, à sa sortie, une tension de sortie, une tension de sortie (UA) rapportée au potentiel de la masse et qui est proportionnelle au signal présent dans la seconde diagonale du pont.